# EUROPEAN PATENT APPLICATION

(11) **EP 2 562 783 A1**
(43) Date of publication of application: **27.02.2013**
(21) Application number: 11777302.8
(22) Date of filing: 19.04.2011
(51) Int. Cl.: H01H 35/40

(54) **WIND BREAK AND METHOD FOR ADJUSTING AND CALIBRATING SAME**

(30) Priority: 19.04.2010 ES 201000500
(71) Applicant: CENTRO DE INVESTIGACIONES ENERGETICAS MEDIOAMBIENTALES Y TECNOLOGICAS (C.I.E.M.A.T.), 28040 Madrid (ES)
(72) Inventor: GARCÍA NAVAJAS, Ginés E., E-28040 - Madrid (ES)
(74) Representative: Garcia-Cabrerizo y del Santo, Pedro Maria
(86) International application number: PCT/ES2011/000131
(87) International publication number: WO 2011/138479

(57) **Abstract**

Wind switch to be installed on outdoor devices to be protected from the wind. The switch comprises a spring, strip or coil (1), which supplies a force opposite to the wind and is physically connected to the surface (5) by one of its extremities, while the other extremity is connected to a fixed point; a surface (5) in the shape of a plate, cylinder or sphere, which is exposed to the wind force and creates a force opposite to the one provided by the spring (1); a permanent magnet (7), physically attached to the surface (5) such that it moves therewith, and two ferrous contacts (11), enclosed under vacuum inside a glass tube (10) and connected to the Local Control Point (17) of each device on which the wind switch is installed.

## Description

### Technical field of the invention

The present invention relates to a wind switch designed to be installed on outdoor equipment, such as solar concentrators, turbines, antennas and mobile structures, etc., which need to be protected from the effects of intense winds with the purpose of safekeeping their integrity. Likewise, the present invention relates to the method for the adjustment and taring of said wind switch.

### Background of the invention

Since the beginning of the eighties, until the start of the new millennium, different initiatives for the development of power plants using thermal-solar concentration technologies have appeared around the world. The purpose of these initiatives is to demonstrate the technical feasibility of power production by means of the use of solar concentrators, such as heliostats and cylindrical-parabolic collectors (CPCs).

To date, there is a large number of thermal-solar plants being planned and built in Spain, and we expect that these initiatives will mean the recovery and leadership of Spanish companies in these technologies.

All of the thermal-solar fields, composed by solar concentrators such as heliostats, CPCs or disks, have large reflective surfaces that are exposed to severe weather and especially to the wind, which is the most important factor to be taken into account to prevent damages to the facilities.

Until now, these solar plants have incorporated safety conditions by means of the measurement and monitoring of instantaneous wind conditions through the use of anemometers.

The Central Control system of the solar plant, which is a computer device that commands and/or monitors all the components of the thermal-solar fields, had been in charge to date of receiving and processing the meteorological information usually originating from a meteorological station located in the vicinity of the thermo-solar field, said system being the only one responsible for commanding the heliostats, CPCs or disks to safe position in the presence of dangerous wind speeds or gusts, making the decision to fold, collapse or safe position in the case of high wind emergency situations. In these conditions, the Central Control informs and commands each one of the Local Control Points, which are the electronic devices that control and manage the operation of an heliostat, a CPC, a disk or any other mobile structure, allowing it carry out all the solar follow-up or positioning functions requested from the Central Control Point, always from the communications system of the solar field. The Local Control Points, in communication with the Central Control Point, execute the command received by using conventional electric power.

To date, no heliostat, CPC or disk has been provided with its own detector for the local decision to fold or assume a defense position in the presence of dangerous winds.

Due to the high cost of heliostats, CPCs or disks, their large size and their significant weakness against intense winds that could damage them, an infallible response that prevents the widespread damage of the solar field must be guaranteed. The objective of the device claimed in this invention is to minimize this risk by allowing the detection of the wind and the independent action of each heliostat, collector or disk.

The wind switch object of the invention is a low-cost device that allows detecting extreme wind conditions so that the facilities or equipment susceptible to suffer damages to their integrity or operation can react and protect themselves on their own. The equipment and facilities to be protected from the wind can be the following:
● Solar concentrators such as disks, cylindrical parabolic collectors or heliostats;
● Wind turbines;
● Antennas and mobile structure such as cranes, davits, drawbridges, telescopes, etc.;

The simplicity and resilience of the concept of the detector distinguish and differentiate this invention.

### Description of the invention

The wind switch of the present invention, designed to be installed on solar concentrators (heliostats, disks, cylindrical parabolic collectors, etc.) or on any other element requiring a safekeeping guarantee in the presence of dangerous winds, comprises the following elements:
● A spring, strip or coil, which is the element that supplies a force opposite to the wind;
● A surface in the form of a plate, a cylinder or a sphere, exposed to the wind and supplying a force opposite to the one offered by the spring;
● A permanent magnet;
● A pair of ferrous contacts enclosed under vacuum inside a glass tube. When the ferrous contacts approach the magnetic field of the magnet, they enter into contact with
each other, forming an electric circuit. The rigidity of the ferrous contacts will break their connection once the magnet moves away and the magnetic field decreases.

The wind switch is connected to the Local Control Point of each device to be protected against the wind through the ferrous contacts, and said Local Control Point starts the safety procedure in the presence of high winds.

The spring is physically connected to the surface by one of its extremities, both of which can be the one and the same element in some applications. The other extremity of the spring is connected to a fixed point (immobile).

The magnet is physically connected to the surface such that it moves therewith.

The ferrous contacts are enclosed under vacuum inside a glass tube, said tube being assembled on a fixed point near the magnet but without being physically in contact thereof. The ferrous contacts remain in contact in stable conditions, without dangerous winds, due to the proximity between them and the magnet.

The surface can move according to the resulting force between the force of the wind and the force of the spring.

The force exerted by the wind on the surface will depend on the speed and direction of the same and the effective surface exposed to the same.

The force provided by the spring will be opposite to the previous force and will depend on its characteristics. The spring will undertake to prevent the movement or displacement of the surface.

A certain wind speed and direction, which we will refer to as THRESHOLD 1, will produce a movement or displacement of the surface when exceeding the counter-reaction of the spring. In these wind conditions, an oscillatory or pulsating movement of the surface and the magnet will take place, causing alterations to the magnetic field, which will, in turn, cause an alternating aperture and closure of the ferrous contacts as long as a second wind threshold is not reached.

If the force of the wind continues to increase towards a second threshold, THRESHOLD 2, the surface will move to the point of no return and the ferrous contacts will remain open continuously.

Threshold 1 and threshold 2 will be delimited by means of the adjustment and taring of the wind switch, which will usually correspond to the following:
THRESHOLD 1: High wind alarm
THRESHOLD 2: Very high wind trigger

The ferrous contacts of the switch will be connected to a digital input of the Local Control Point of the applicable heliostat, CPC, disk or equipment and said local control point will execute the emergency procedure established for each case once the two thresholds established are detected.

The wind switch has to be subjected to an adjustment and taring procedure which will consist in submitting the device to real wind conditions so that the activation of the device takes place at the desired thresholds.

The adjustment and taring procedure consists in:
1. Verifying that the wind speed is below 1 m/s, without the presence of meteors and at a moderate room temperature;
2. Assembling the switch outside a vehicle, such that it moves therewith and there are no objects that could affect the effect of the wind on the same;
3. Connecting the ferrous contacts to an electrical resistance meter with the purpose of knowing the state of aperture or closure of the same from within the vehicle;
4. Starting the vehicle and circulating through straight highway sections with good road sources and free of traffic, accelerating progressively until reaching a speed at which an oscillation of the surface of the switch and an alternating aperture and closure of the ferrous contacts takes place, maintaining the speed and noting the value of THRESHOLD 1;
5. Keep accelerating progressively until verifying that the ferrous contacts remain open at all times, maintaining the speed and noting the value of THRESHOLD 2;
6. Modifying the characteristics of the spring (length, size...) and of the surface with the purpose of approximating the values obtained experimentally to the desired thresholds;
7. Repeat the previous steps until the desired adjustment and taring is obtained. 4 to 6 times is enough.

The switch object of the present invention presents the following advantages:
● Great simplicity, being composed by passive components that do not require electric power for their operation, granting it greater security;
● Great simplicity and low cost, allowing it to be incorporated on all devices to be protected from the wind without making the system much more expensive;
● Great resilience and reliability in the detection due to being activated by the wind force;
● Easy to adjust and tare by means of the procedure object of the present invention;
● Very versatile, since it allows detections in different wind directions and conditions, as well as several alarm levels (high and very high).
● The use of wind switches such as the one of the present invention, on each device or facility to be protected from the wind, provides greater safety and dispersion of risk than the procedure being used until now, in which one or several devices, usually anemometers, inform a Central Control that transfers the emergency to all the devices and facilities by means of cabled or fiber communications. The device object of the invention will allow a personalized supervision and safekeeping of each piece of equipment, without requiring the intervention of the Central Control of the solar field.

### Brief description of the drawings

Next, in order to complete the description being made and with the purpose of helping to provide a better comprehension of the characteristics of invention, a detailed description of a preferred embodiment will be made based on a set of drawings representing the following by way of illustration and not by way of limitation, which accompany this specification:
Figure 1 shows a perspective view of the wind switch;
Figure 2 shows another perspective view of the wind switch;
Figure 3 shows an autonomous heliostat, on whose photovoltaic plate the wind switch has been assembled;

In the figures described, the numeric references correspond to the following parts and elements:
1. Spring
2. Screw
3. Nut, locknut and clamping washer set from the spring to the angular support
4. Angular support
5. Surface (aluminum plate)
6. Nut, locknut and clamping washer set from the spring to the surface
7. Magnet
8. Nut, locknut and clamping washer set from the angular support to the airtight box
9. Airtight box made from a non-magnetic material
10. Glass ampoule
11. Ferrous contacts
12. Terminal and rail
13. Cables for the digital input of the local control point and press
14. Surface exposed to the wind of the autonomous heliostat
15. Pedestal of the autonomous heliostat
16. Head or mechanism of the heliostat
17. Local control point
18. Photovoltaic plate
19. Angular position measurement and/or detection system
20. Radio modem
21. Wind switch
22. Movement system (engine)

### Description of a preferred embodiment

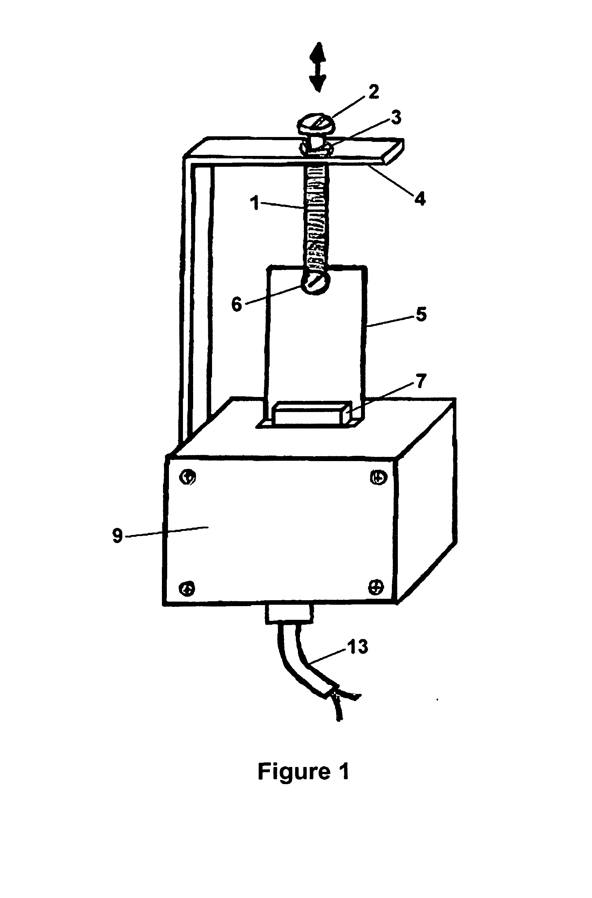

As shown in figure 1, the wind switch is formed by a traction spring (1) measuring 6 mm in diameter and 32 mm in length, manufactured from stainless steel thread.

This spring is wound to a stainless steel screw (2), which fixes the spring to a commercial 90x90 mm angular support (4) by means of a nut, a clamping washer and a locknut (3).

The other extremity of the spring is fixed to a surface (5), which is a small aluminum plate, 40x23 mm long and 1 mm thick, by drilling on the plate and by means of a screw with a nut and a clamping washer (6).

The aluminum plate (5) has a 90° fold in its lower part with a 5 mm-wing, where a magnet (7) rests and is fixed by means of an adhesive. The dimensions of this magnet (7) are 19x3x3 mm.

The angular support (4) is fixed by means of a screw, washer and nut (8) to an airtight box (9) made from a non-magnetic material. By adjusting the screw (2), the angular support is brought closer to the lower part of the surface (aluminum plate) (5) until a light of approximately 1 mm between the wall of the box (9) and the magnet (7) is obtained.

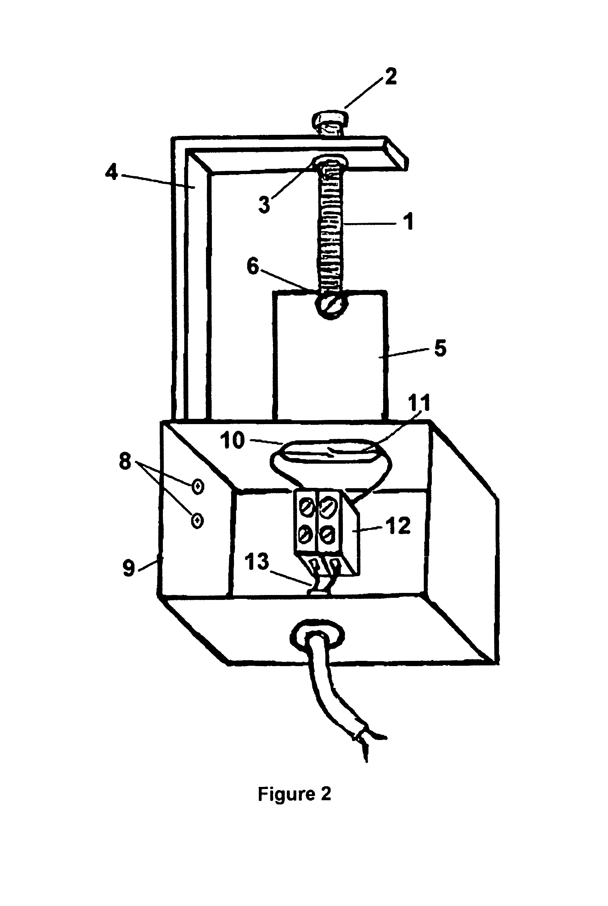

As shown in figure 2, the glass ampoule or tube (10), which holds the ferrous contacts (11) within, is fixed on the wall and the vicinity of the magnet (7) by means of silicone, so that said ampoule (10) is adhered in line with and just below the magnet (7).

The ferrous contacts (11) are welded to two conductive threads, which are connected to a standard terminal (12) inside the box (9).

The conductors of the electric hose originating from the digital input of the Local Control Point (17) of the heliostat are connected from this terminal (12).

This device, conceived as described above, is adjusted and tared by means of the procedure described below, establishing the following threshold values:
THRESHOLD 1: High Wind Alarm: 60 Km/h
THRESHOLD 2: Very High Wind Trigger: 70 Km/h

The steps of the adjustment and taring method are the following:
1. Verifying that the wind speed is below 1 m/s, without the presence of meteors and at a moderate room temperature;
2. Assembling the switch (21) outside a vehicle, such that it moves therewith and there are no objects that could affect the effect of the wind on the same;
3. Connecting the ferrous contacts (11) to an electrical resistance meter with the purpose of knowing the state of aperture or closure of said contacts (11) from within the vehicle;
4. Starting the vehicle and circulating through straight highway sections with good road sources and free of traffic, accelerating progressively until reaching a speed at which an oscillation of the surface (5) of the switch (21) and an alternating aperture and closure of the ferrous contacts (11) takes place, maintaining the speed and noting the value of THRESHOLD 1;
5. Keep accelerating progressively until verifying that the ferrous contacts (11) remain open at all times, maintaining the speed and noting the value of THRESHOLD 2;
6. Modifying the characteristics of the spring (1) (length, size...) and of the surface (5) with the purpose of approximating the values obtained experimentally to the desired thresholds;
7. Repeating the previous steps until the desired adjustment and taring is obtained. 4 to 6 times is enough.

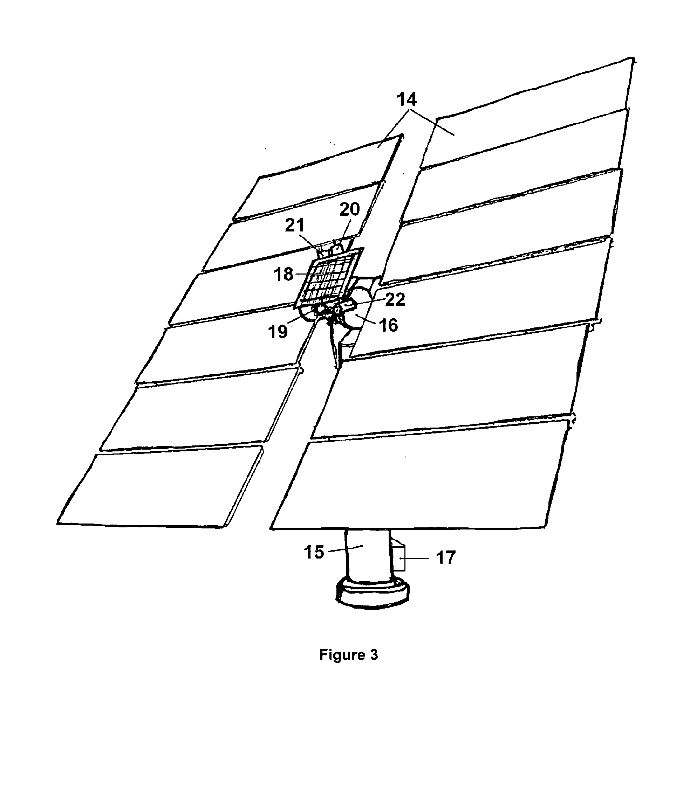

As shown in figure 3, this device has been installed along with the radio modem (20) in the upper part of the photovoltaic plate (18) of an autonomous heliostat. The wind switch (21) and the photovoltaic plate (18) move along with the azimuth axis of the heliostat, so that the wind switch (21) becomes sensitive to the most dangerous wind directions for the reflective surface (14) of the autonomous heliostat exposed to the wind.

This device is especially conceived to guarantee the integrity, against intense winds, of those elements which, managed by a Local Control Point (17) work or can work in an autonomous fashion; when extra safety measures are desired; and ultimately, when the safety protection and procedures of the plant have failed.

The devices on which the wind switch (21) is installed comprise a surface exposed to the wind (14), a movement system based on one or several axes (22) and an angular position measurement and/or detection system (19) in addition to the Local Control Point (17) for controlling movement.

Even though it may be used on any facility requiring this protection with the aforementioned characteristics, the invention is especially conceived to be used on autonomous heliostats. These heliostats come with an autonomous power supply system, rendering them independent from possible perturbations to the conventional electrical supply and thus guaranteeing this protection to a larger extent.

## Claims

1. Wind switch to be installed on outdoor equipment to be protected from the wind, with the purpose of safekeeping their integrity, **characterized in that** it comprises:
● A spring, strip or coil (1) which is the element that supplies a force opposite to the wind, and is physically connected to the surface (5) by one of its extremities, while the other extremity is connected to a fixed point
● A surface (5) in the form of a plate, a cylinder or a sphere, exposed to the wind and supplying a force opposite to the one offered by the spring (1);
● A permanent magnet (7), physically attached to the surface (5) such that it moves therewith,
● A pair of ferrous contacts (11) enclosed under vacuum inside a glass tube (10), said tube being assembled on a fixed point near the magnet (7) but without being physically in contact thereof. In turn, said contacts (11) are connected to the Local Control Point (17) of each device on which the invention is installed;

2. Wind switch to be installed on outdoor equipment to be protected from the wind, according to claim 1, **characterized in that,** when the counter reaction of the spring (1) is exceeded at a certain wind speed and direction (THRESHOLD 1), a movement or displacement of the surface (5) and the magnet (7) takes place, causing alterations to the magnetic field and, therefore, the alternating aperture and closure of the ferrous contacts (11); and, if the action of the wind continues to increase to a second threshold (THRESHOLD 2), the surface (5) moves to the point of no return and the ferrous contacts (11) remain open continuously, so that the Local Control Point (17) of the equipment exposed outdoors and connected to the ferrous contacts (11) executes the emergency procedure established for each case once the two thresholds established are detected;

3. Wind switch to be installed on outdoor equipment to be protected from the wind, according to claim 1, **characterized in that** the devices exposed outdoors needing to be protected from the wind comprise the following:
- a surface exposed to the wind (14)
- a movement system based on one or several axes (22)
- an angular position measurement and/or detection system (19)
- a Local Control Point for controlling movement (17)

4. Wind switch to be installed on outdoor equipment to be protected from the wind, according to claim 1, **characterized in that** the spring (1) measures 6 mm in diameter and 32 mm in length and is manufactured from stainless steel thread; the surface (5) is a small aluminum surface, 40x23 mm long and 1 mm thick, which has a 90° fold in its lower part with a 5 mm-wing, where a magnet (7) rests and is fixed by means of an adhesive. The dimensions of this magnet (7) are 19x3x3 mm.

5. The adjustment and taring procedure of the wind switch of claim 1 consists in:
1. Verifying that the wind speed is below 1 m/s, without the presence of meteors and at a moderate room temperature;
2. Assembling the switch (21) outside a vehicle, such that it moves therewith and there are no objects that could affect the effect of the wind on the same;
3. Connecting the ferrous contacts (11) to an electrical resistance meter with the purpose of knowing the state of aperture or closure of said contacts (11) from within the vehicle;
4. Starting the vehicle and circulating through straight highway sections with good road sources and free of traffic, accelerating progressively until reaching a speed at which an oscillation of the surface (5) of the switch (21) and an alternating aperture and closure of the ferrous contacts (11) takes place, maintaining the speed and noting the value of THRESHOLD 1;
5. Keep accelerating progressively until verifying that the ferrous contacts (11) remain open at all times, maintaining the speed and noting the value of THRESHOLD 2;
6. Modifying the characteristics of the spring (1) (length, size...) and of the surface (5) with the purpose of approximating the values obtained experimentally to the desired thresholds;
7. Repeat the previous steps until the desired adjustment and taring is obtained.

6. The adjustment and taring procedure of the wind switch of claim 5, where THRESHOLD 1 corresponds to the high wind alarm at 60 Km/h and THRESHOLD 2 corresponds to the very high wind trigger at 70 Km/h.
